Europäisches Patentamt

European Patent Office

Office européen des brevets

(19)

(11) Publication number: **0 087 320**
**A2**

(12) **EUROPEAN PATENT APPLICATION**

(21) Application number: **83300944.2**

(22) Date of filing: **23.02.83**

(51) Int. Cl.³: **G 11 C 7/00**

(30) Priority: **23.02.82 GB 8205332**

(43) Date of publication of application:
**31.08.83 Bulletin 83/35**

(84) Designated Contracting States:
**DE FR GB**

(71) Applicant: **Daniels, Stanley**
**57, Hackford Road**
**Winterbourne Bristol BS17 1DX(GB)**

(72) Inventor: **Daniels, Stanley**
**57, Hackford Road**
**Winterbourne Bristol BS17 1DX(GB)**

(74) Representative: **Shindler, Nigel et al,**
**BATCHELLOR, KIRK & EYLES 2 Pear Tree Court**
**Farringdon Road**
**London EC1R 0DS(GB)**

(54) Digital sound storage system.

(57) An audio-signal storage and playback system comprising a solid state module in which a series of digitised data signals representing audio signals are recorded sequentially, and a replay unit into which the module is plugged by means of a plug and socket arrangement having connectors A-F. The replay unit includes digital-to-analogue converters and audio amplifiers (110, 118) (108, 116) for each channel and preselector means (126) to enable the operator to select the point in the recording at which replay begins.

FIG.2.

EP 0 087 320 A2

Croydon Printing Company Ltd

## DIGITAL SOUND STORAGE SYSTEM

This Invention relates to a method of recording, storage and
playback (replay) of audio frequency data, typically music and
speech, which is commonly to be found at present stored in the
form of gramophone records or magnetic tape cassettes.  The
original source of the data can be from an analogue signal (a
musical instrument) or a digital signal which has the
characteristics allowing it to be stored, after suitable
processing, in a similar fashion to an audio frequency
analogue signal.  Although the invention is applicable to all
forms of audio frequency data or information it is
particularly applicable to recorded music for sale to the
general public.  Hereinafter the data or information to be
stored will be referred to as music.

The traditional methods of recording music have always relied
upon the storage of the information in one medium and the
processing of that information in another.  For instance in
the case of gramophone records the storage is a mechanically
transcribed track on a plastic disc and the signal processing
is electronic.  In the case of a cassette recording, the
storage is a magnetic orientation of the magnetic material on
tape again with electronic signal processing.  Degradation of
the original music usually arises in the storage stage and the
transcription from the storage medium to the electronic stage
whilst the dilution of quality in the  electronic
amplification stage of reproduction is negligeable.

The overriding problems of reproduction have centered around

the transfer of information from the storage media to the electronic processing.

For gramophone records this involves:

- avoiding damage to the tracks of the record,
  maintaining the turntable at a constant speed, not only over a long period of time but also ensuring that this speed is constant and ripple free throughout each revolution,
- keeping the playing surface free from dust and dirt,
  keeping the pressure from the stylus at a very low but correct level,
- replacing the stylus as it becomes worn,
- allowing freedom of movement of the pick-up arm,
- generally keeping the whole apparatus horizontal,
- preventing vibrations from being transmitted to the record,
- keeping the records away from excessive heat whilst being stored,

and for tape recordings:

- keeping the replay head clean and free from dust,
- maintaing constant tape speed,
- storing the tapes away from stray magnetic fields,
- maintaining accurate alignment of tape and replay head,
- preventing magnetic imprinting of one track to its adjacent track when tightly wound,
- preventing oxide build-up on the replay head,
- proper selection of magnetic media to obtain the desired frequency range and an acceptably low level of noise,
- prevention of wow and flutter in the system,
- correction of permanent magnetisation of the replay head.
- selection of tape of constant and regular thickness over its

playing length.

This invention seeks to provide a method of storing music such that these traditional major problems are overcome, so as to maintain the original quality of the stored music allowing it to be repeatedly replayed at its original level of quality and not be subject to degradations in quality over periods of time as is the case with the currently available methods.

This invention will allow the music to be stored in a more robust fashion than in the methods it can replace. Further, a preferred embodiment of this invention, when used in a replay system will generally use less power to reproduce the music as no moving parts are required. Also this embodiment will enable an equal amount of music to be stored in a smaller volume than a record or cassette so giving even more advantages to portable replay equipment.

According to the present invention, music is stored in an electronic fashion in an electronic memory. The music is converted to a digital signal and it is this digital signal which is stored in the memory. The electronic memory can be of a type known as a 'read-only-memory' or an electronic memory that can be both 'read-and-write' for the user. In the first type the storage can be performed by a manufacturer as happens in the case of gramophone records; the user can only replay them and cannot alter that which is already stored on the plastic disc. In this instance the most suitable type of electronic memory will be the 'read-only-memory' type. In the second type the music can be stored as is arranged for a tape cassette; the music stored on the tape can be erased and

replaced as the user requires but may also have been pre-recorded by a manufacturer. For this type of use the electronic memory will need to be of a 'read-and-write' type.

Preferably, the electronic memory comprises one or more memory circuits (e.g. silicon chips) mounted as a module which contains all the necessary memory, and the necessary interconnecting circuitry. The module is preferably so constructed as to be easily connected and disconnected from its replay equipment (e.g. in a "plug-in" arrangement), using a small number of electrical interconnecting contacts with the replay equipment. These contacts are preferrably suitably protected from damage both mechanical and electrical. The module is also preferrably of a size comparable with equivalent plug-in modules for domestic use typically no bigger than a tape cassette but not too small to be easily lost.

In a practical application of the invention, for storage of commercial sound recordings, the music is preferrably converted to a digital form in the recording studio affording it the least possible degradation. It is then stored in a digital fashion in the memory and is replayed into the replay equipment in a digital fashion, being converted to an analogue form in the replay equipment preferrably just prior to being amplified and fed to the speakers. As the recording, storage and replay are all electronic and all in the same digital format then all of the problems listed above involving changes of media and format etc. are completely circumvented. Further, the recording is permanent and does not degrade with time.

In a preferred arrangement, the module can have six individual connections arranged as follows:-

   -two for the power supply,

   -two for the music out (serial data), one line for each
    channel of stereo,

   -one for the synchronising module clock pulse signal in,

   -one for a serial signal in to preset the starting point of
    the replay,

If only mono-aural music is to be replayed then the number of
lines is reduced by one. Alternatively two further lines may be
provided for two channels of stereo music to be input to the
module for a 'Read-and-Write' arrangement.

The digitising of speech signals may be carried out at 8000
samples per second, i.e. 8kHz. Music needs a higher sampling
rate. For excellent reproduction, 80kHz is necessary (double
for stereo). Very good reproduction can be obtained with 40kHz
and for low quality (some popular music records) 20kHz is all
that is needed. The subsequent encoding may use linear PCM
(pulse-coded modulation) which needs 14 bits per sample, whilst
companded sampling can be done with 12 bits per sample. Delta
modulation needs a reduced number of bits but will need an
increased sampling rate. Predictive filtering and other
techniques that could be assimilated into an 'intelligent'
replay equipment may be used to reduce the total volume of
storage by a reasonable amount.

An Embodiment of the invention will now be considered. The
storage requirements for this embodiment can be assessed from
reviewing a good quality music requirement. The music has been assumed to be encoded by Linear PCM (Pulse Code Modulation) using a measure of companding resulting in a digitisation of 12 bits per sample. The music has been sampled at 30,000 samples per second (x 60 seconds per minute = 1,800,000 samples per minute). At 12 bits per sample this produces 21.6 Megabits per minute of storage, say 20 Megabits of storage per minute of recording.

In the embodiment no measure of predictive filtering has been assumed for the replay equipment and no sophisticated memory-saving arrangements or codes etc. have been assumed. The embodiment uses the 'Read-only-Memory' arrangement of the invention.

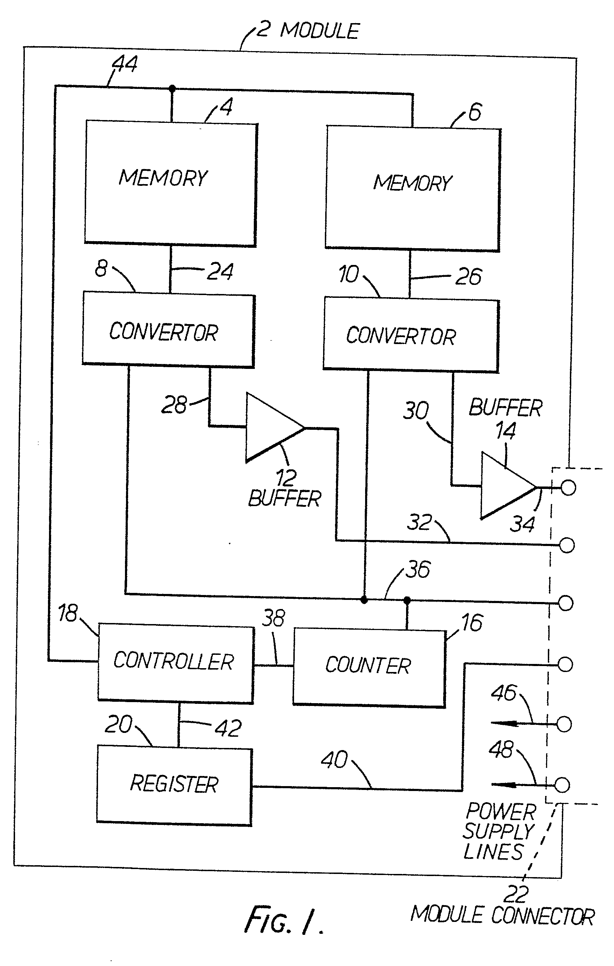

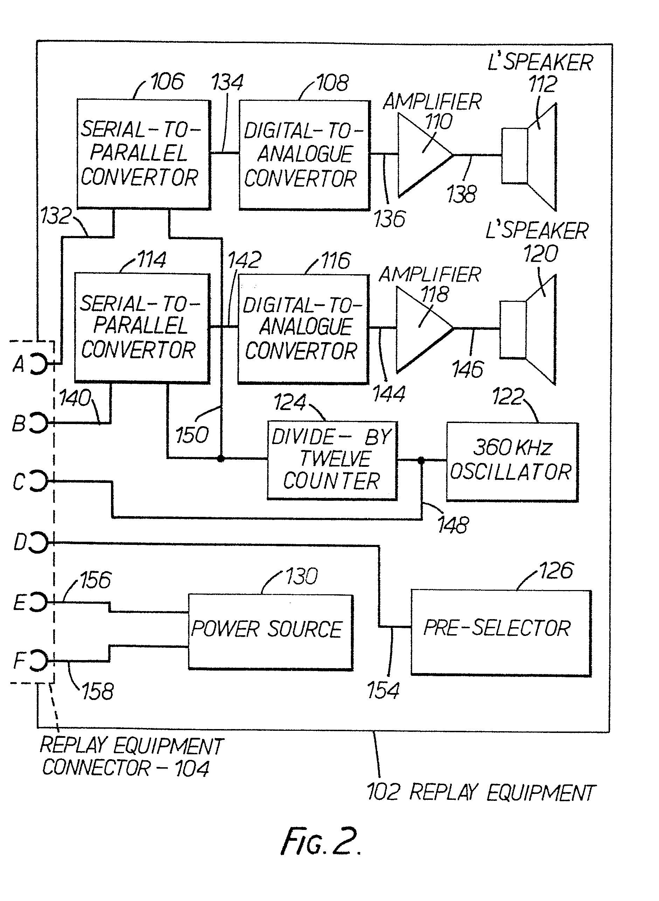

The component parts of the embodiment and its principle of operation will now be described with reference to figures 1 and 2. Figure 1 shows the electronic system arrangement and interconnections within a module and figure 2 shows the way by which the module would interact with a replay equipment.

With reference to figure 1, the Module, 2, is shown comprising Memories 4 and 6, Converters 8 and 10, Buffers 12 and 14, Counter 16, Controller 18, Register 20, various interconnections (Lines 24, 26, 28, 30, 32, 34, 36, 38, 40, 42, 44, 46 and 48) and a Module Connector, 22.

Memory 4 contains all of the previously-stored music for the left channel of stereo music. Memory 6 contains the stored music for the right channel.

Converters 8 and 10 are parallel-to-serial converters, accepting 12 bit parallel input data and outputting serial

data. The output of Memory 4 is connected to the input of Converter 8 by Line 24. Line 24 comprises 12 individual interconnections. Likewise the output of Memory 6 is connected to the input of Converter 10 by Line 26, Line 26 again having 12 individual interconnections. The data from the Memories 4 and 6, one word of 12 bits from each Memory, is transferred word by word to Converters 8 and 10 by the action of the 30kHz signal on Line 38 and the serial data is clocked out from Converters 8 and 10 by the Module Clock, Line 36; both of which signals are described in more detail below.

Buffers 12 and 14 are used to ampilfy the serial output of the Converters; Lines 28 and 30 connect the outputs of Converters 8 and 10 to the inputs of Buffers 12 and 14 respectively. The outputs of Buffers 12 and 14 are connected to pins A and B of the Module Connector, 22, via Lines 32 and 34; Lines 32 and 34 being single interconnections each. The replay equipment would normally connect with these pins and process the encoded music into an audio form. An arrangement of the replay equipment is described below.

In the event that the module is intended solely for mono-aural music then only one channel would be required; Memory 6, Converter 10, Buffer 14, Lines 26, 30, 34 and pin A of the Module Connector would not be included.

Counter 16 is a 'Divide-by-Twelve Register'. Its input signal emmanates from the replay equipment arriving at the module on pin C of the Module Connector, 14, and linked to Counter 16 by Line 36, a single interconnection. It is termed the Module Clock and in this embodiment is at a frequency of 360,000 pulses per second (360kHz). The output of Counter 16, at 30kHz, is directed to Controller 18 via Line 38, a single interconnection. The Module Clock contains an arrangement of a synchronising signal every twelfth pulse such that the 30kHz signal derived inside the module is in synchronism with the similar 30kHz signal in the replay equipment.

Controller 18 acts as a 'Current Memory Location Controller' and is incremented by the 30kHz signal, Line 38, from Counter 16. Its size will be dependent on the length of the music stored and will generally be between 24 to 28 stages of pure binary counting. In this embodiment it will be assumed to be 26 stages. The output signal of 26 bits from Controller 18 is directed to Memory 4 and Memory 6 via Line 44, Line 44 comprising 26 individual interconnections. Controller 18 has also a secondary input from Register 20. When an input is received from Register 20, via line 42 again of 26 individual interconnections, Controller 18 assumes the value given to it from Register 20.

Register 20 is a 'Start-at-Zero and Pre-Selection Register'. It is controlled by an occasional signal from the replay equipment. This signal, the Pre-Select signal, enters the Module on pin D of the Module Connector and is a serial digital word of 26 bits in length. The signal is self-clocking and also contains an end-of-word characteristic feature allowing Register 20 to detect that it has received all of the data and then proceed to present this data as an input to Controller 18. This signal is transferred from the Module Connector to Register 20 via Line 40, a single interconnection.

The two other pins of the Module Connector, E and F, are used
to provide electrical power to the Module. Lines 46 and 48
accomplish the power distribution to all of the components.

The principle of operation of the embodiment will be described
using the arrangement having a 'Read-only-Memory' type, such
that the encoded music has previously been stored in Memories 4
and 6 during manufacture of the module and cannot be
subsequently altered.

Figure 2 shows an arrangement whereby the Module is connected
into a replay equipment. The Replay Equipment shows the
electronic components and their interconnection arrangements.
The Connector on the Replay Equipment, 104, is a mating
connector for the Connector on the Module, 22, (a plug and
socket).

The 360kHz Oscillator, 122, feeds, via Line 148, the
Divide-by-Twelve Counter, 124, and, via pin C of the Connector,
Counter 16 in the Module. These Counters are similar in design
and because of an arrangement of synchronising signal every
twelfth pulse of the 360kHz from Oscillator 122, the 30kHz
outputs from both Counter 124 and Counter 16 are in
synchronisation.

A serial data word (of 12 bits) is received from the Module on
pin A of the Connector and is routed via Line 132 to
Serial-to-Parallel Convertor 106. When the final bit of the
word has been received by Convertor 106, the parallel word is
presented to Digital-to-Analogue Convertor 108, via line 134,
by the action of the 30 kHz signal on Line 150. Line 134 has 12 interconnections. The output of Convertor 108 is fed to Audio Amplifier 110 via Line 136 and thence to Loudspeaker 112 via Line 138. Amplifier 110 has the normal controls of a conventional amplifier, volume, bass, treble etc. The conversion process is repeated at a rate of 30,000 words per second.

The second channel of stereo music is processed in exactly the same fashion via pin B, Line 140, Serial-to-Parallel Convertor 114, Line 142, Digital-to-Analogue Convertor 116, Line 144, Audio Amplifier 118, Line 146 and Loudspeaker 120.

The Power Source 130 provides the necessary electrical power for the arrangement and feeds via Lines 156 and 158 to pins E and F of the Connector.

A Pre-Selector, 126, is provided. Its output is taken via Line 154 to pin D of the Connector. The operator, using selection switches on the Pre-Selector, will be able to start the replay from any point in the piece of music. The result of the operators selection is coded into a serial data word and transmitted to Register 20 in the module. In the absence of any positive action by the operator, the replay would be commanded to start at the beginning of the music.

The Module is easily disconnected and removed from the Replay Equipment allowing another Module to be inserted into the Replay Equipment and hence new music to be replayed.

-11-

CLAIMS:

1.      An audio signal storage and playback system comprising a solid state module in which a series of digitised data signals representing audio signals are recorded in a sequential fashion, and a replay unit including means for accessing the signal in the module and reading them out sequentially, digital-to-analogue conversion means for converting the sequential digital signals into a continuously varying analogue signal, amplifier means for amplifying the analogue signal, and control means to enable an oprator to control the replay unit, the module and the replay unit including cooperating means whereby the module may be plugged into the replay unit to establish electrical connections . between them.

2.      An audio signal storage and playback system according to claim 1 in which the module comprises a reprogrammable device and the replay unit further comprises analogue-to-digital conversion means for recording audio signals in the module.

3.      An audio signal storage and playback system according to claim 1 in which the module comprises a read only memory.

4.      An audio signal storage and playback system according to any preceding claim in which the said replay unit further comprises a clock signal generating circuit arranged to control the output from the module at a required playback speed.

5.      An audio signal storage and replay system according to any preceding claim further comprising

-12-

manually controllable preselector means adapted to apply a signal to the module to initiate replay of the stored signals from a preselected point in the series of digitised signals.

6.      An audio signal storage and replay system according to any preceding claim in which the said module comprises a semiconductor memory.

7.      An audio signal storage and replay system according to any preceding claim in which the said module comprises a bubble memory.

8.      An audio signal storage and replay system according to claim 2 or any of claims 4 to 7 when dependent on claim 2, in which the replay unit includes means for time encoding the audio signal when it is recorded in such a way as to economise on storage space.

9.      An audio signal storage and replay system according to any preceding claim in which the replay unit includes means for decoding recorded digital data which has been time encoded on recording.

0087320

*FIG. 1.*

FIG.2.